# EUROPEAN PATENT APPLICATION

(11) **EP 2 416 165 A1**
(43) Date of publication of application: **08.02.2012**
(21) Application number: 10171871.6
(22) Date of filing: 04.08.2010
(51) Int. Cl.: G01Q 30/02, G01Q 30/10, G01Q 30/16, G01Q 30/20, G01N 1/42, H01J 37/305

(54) **Method of forming a 3D reconstruction of a sample using a scanning probe microscope**

(71) Applicant: FEI Company, Hillsboro, OR 97124-5793 (US)
(72) Inventor: Stokes, Deborah, 5611 XD Eindhoven (NL); Geurts, Remco, 5345 AW Oss (NL); Hubert, Dominicus, 5615 JT Eindhoven (NL); Barber, Asa, London E1 4NS (GB)
(74) Representative: Bakker, Hendrik

(57) **Abstract**

The invention relates to a method of inspecting a sample (101), the method comprising:
repeatedly
• Preparing a fresh surface (304,306) on the block face of a sample by removing the surface layer,
• Inspecting the block face with a scanning probe microscope (100), resulting in information of the current surface layer,

Followed by
• Combining the information of a multitude of inspections into a 3D reconstruction of the sample,

Characterized in that
The removal is performed in an evacuated environment by ion beam milling.

By performing the removal of the surface with ion beam milling, mechanical deformations are avoided, surface roughness is reduced, and the vertical resolution is enhanced, resulting in a better 3D reconstruction of the sample.

## Description

The invention relates to a method of inspecting a sample, the method comprising:
repeatedly
   - preparing a fresh surface on the block face of a sample by removing the surface layer,
   - inspecting the block face with a scanning probe microscope, resulting in information of the current surface layer,
followed by
   - combining the information of a multitude of inspections into a 3D reconstruction of the sample,

Such a method is known from e.g."Atomic force microscope (AFM) combined with the ultramicrotome: a novel device for the serial section tomography and AFM/TEM complementary structural analysis of biological and polymer samples", A.E. Efimov et al., Journal of Microscopy, Vol. 226, Pt. 3 June 2007, pp. 207-217.

In the known publication an instrument is described that is formed by integrating an Atomic Force Microscope (AFM) with an ultramicrotome. The ultramicrotome, a commercially available apparatus known as such, is capable of sectioning a sample and removing extremely thin slices from a block face. According to the article the thickness removed can be adjusted from 20 nm to 2000 nm, although other sources report thicknesses of 50 nm upwards.
After exposing a fresh surface by removing a surface layer from a block face of the sample with the ultramicrotome, the integrated AFM is used to form an image of the block face.
By repeating the sectioning and imaging each fresh surface, a stack of images is formed that can be used to form a 3D reconstruction of the sample.

A known problem with sectioning is the deformations that may occur due to the forces exposed to the sample during sectioning. This problem is described in e.g. "An oscillating cryo-knife reduces cutting-induced deformation of vitreous ultrathin sections", A. Al-Amoudi et al., Journal of Microscopy, Vol. 212 Issue 1, Pages 26 - 33.

A related problem is that the surface roughness that can be achieved with ultramicrotoming is limited to such a degree that it limits the image quality

Yet another problem of the apparatus described by Efimov is that the apparatus is not equipped to operate at cryogenic temperatures, more specifically at a temperature below the glass transition temperature of water, as this requires operation of both the ultramicrotome and the AFM in vacuum. Should the apparatus be able to operate at a cryogenic temperature in atmosphere, water from the atmosphere would condense on the sample and form an ice layer.
It is mentioned that it is known to operate ultramicrotomes at cryogenic temperatures, and to preserve the thus formed samples in e.g. boiling nitrogen, and then handle them in vacuum. However, the apparatus of Efimov is not equipped for this, and modifications to make is work that way are expensive and make operation of the apparatus cumbersome

Still another problem is that, although a layer of 20 nm is a very thin layer, it is much more than the typical lateral resolution of the AFM. As a result the resolution in the 3D reconstruction in the plane of the surface will be much higher than the resolution vertical to said surface.

It is an objective of the invention to provide a method in which deformation due to mechanical forces is absent.

It is a further objective of the invention to provide a method in which the block face is observed at a cryogenic temperature.

It is a further objective of the invention to provide a method in which the resolution in the plane vertical to the surface can be increased.

To that end the method according to the invention is characterized in that the removal is performed in an evacuated environment by ion beam milling.

It is noted that ion beam milling in this context is the removal of material due to bombardment with energetic ions, such as is the case in Focused Ion Beam (FIB) milling, Enhanced FIB milling, Reactive Ion Etching (RIE), but also exposing the sample to an unfocused ion beam.

By using ion beam milling to remove the surface layer from the block face, no forces are exerted to the block face, and thus no mechanical deformations are induced.

The layer thickness removed by FIB milling can be regulated to a much smaller thickness than the mechanical removal with an ultramicrotome. Typically the thickness of a layer removed with a FIB can be adjusted with a resolution of one nanometer.

The surface roughness of a surface milled with an ion beam can be extremely small. Surface roughness values as low as 2 nm_{RMS} are reported. Therefore the SPM images of a sample that is milled with an ion beam are of a better quality than those in which an ulmicrotome is used to remove material.

As ion beam milling takes place in a vacuum, removal of material can be performed at low temperatures. Such cryo-FIBs are formed, for example, by mounting a Gatan Alto 2500 cryo-transfer system from Gatan Inc., Pleasanton, California, USA, on a Quanta 3D DualBeam^{™} from FEI Company, Hillsboro, Oregon, USA,

In a preferred embodiment the ion beam milling is focused ion beam milling.

Focused ion beam milling is a well known technique in which a focused beam of energetic ions (with an energy that is chosen, for example, between 500 eV to 50 keV) is scanned over the surface of a sample.

In another embodiment of the method according to the invention the milling is performed in a vacuum chamber and an etchant is introduced in the vacuum chamber during the ion beam milling.

By introducing an etchant into the vacuum chamber the milling rate is increased, and thus throughput time for the milling step decreased. The etchant can be introduced to the chamber (resulting in a substantially constant pressure of the etchant in the chamber) or via a gas injection system (GIS) leading to a localized increase of pressure. Both methods are known to the skilled person.

In yet another embodiment of the method according to the invention the scanning probe microscope is a Atomic Force Microscope (AFM), a Ballistic Electron Emission Microscope (BEEM), a Chemical Force Microscope (CFM), a Conductive Atomic Force Microscope (C-AFM), an Electrostatic Force Microscope (EFM), a Force Modulation Microscope (FMM), a Kelvin Probe Force Microscope (KPFM), a Magnetic Force Microscope (MFM), a Magnetic Resonance Force Microscope (MRFM), a Scanning Near-Field Optical Microscope (SNOM), a Piezoresponse Force Microscope (PFM), a Photon Scanning Tunneling Microscope (PSTM), a Photothermal Microspectroscopy Microscope (PTMS), a Scanning ElectroChemical Microscope (SECM), a Scanning Capacitance Microscope (SCM), a Scanning Gate Microscope (SGM), a Scanning lon-Conductance Microscope (SICM), a Spin Polarized Scanning Tunneling Microscope (SP-STM), a Scanning Spreading Resistance Microscope (SSRM) a Scanning Thermal Microscope (SThM), a Scanning Tunneling Microscope (STM), a Scanning Voltage Microscope (SVM), or a Scanning Hall Probe Microscope (SHPM).

A scanning Probe Microscope is a device that scans a sharp probe over the surface of a sample. The microscope can be equipped to measure one of many phenomena while kept at a constant average distance from the sample, or the microscope can be equipped to use one of the phenomena in a feedback loop to keep e.g. the local distance from the probe to the sample constant. Among the most well-known variants of the SPM is the STM, in which the current tunneling from the probe to the sample is used in the feedback loop, and the AFM, in which the force on a vibrating cantilever is used in the feedback loop. In this way surface information, including chemical composition (CFM and SECM), magnetization (SHPM), can be determined.

It is noted that a SPM of a specific type may be used in one or more specific modes, giving even more specific information. An example of that is the AFM, that can be used in contact mode, non-contact mode, dynamic contact mode, tapping mode and phase contrast mode.

In another embodiment of the method according to the invention inspecting the sample further comprises inspecting the sample with FIB imaging, resulting in one or more supplemental 3D maps of the sample.

Using a FIB a beam of energetic ions impinges on the sample. As a result secondary radiation in the form of e.g. secondary ions and/or electrons emanate from the sample. This radiation can be detected with a suitable detector, and the signal of the detector used to form an image of the surface, to be integrated in a supplemental 3D map of the sample.

In still another embodiment of the method according to the invention inspecting the sample further includes inspecting the sample with a focused electron beam, resulting in one or more supplemental 3D maps of the sample.

Using a focused electron beam, as produced by a Scanning Electron Microscope, a beam of energetic electrons impinges on the sample. As a result secondary radiation in the form of e.g. secondary electrons, back-scattered electrons, photons, and X-rays, emanate from the sample. This radiation can be detected with a suitable detector, and the signal of the detector used to form an image of the surface, to be integrated in a supplemental 3D map of the sample.

In yet another embodiment of the method according to the invention the thickness of the removed layer of material is determined with the scanning probe microscope.

A scanning probe microscope is well suited to determine height steps in the surface. By subsequently removing surfaces that fit into each other, that is: the perimeter of the more recently removed surface completely surrounded by the perimeters of earlier removed surfaces, the scanning probe microscope can determine the steps and determine to total thickness of the removed layers. Also when removing surfaces that do not fit within each other the step with respect to the original surface can be determined.

In yet another embodiment of the method according to the invention which the scanning probe microscope operates in vacuum.

Although not necessary for the invention, preferably the scanning probe microscope is situated in the vacuum chamber of the ion beam apparatus. In this way e.g. no time is lost for evacuating the sample before milling.

In yet another embodiment of the method according to the invention the sample is a biological sample or a polymer.

In yet another embodiment of the method according to the invention the sample is a sample at cryogenic temperature, and the AFM is operates in vacuum at a cryogenic temperature.

When combining SPM imaging with scanning electron microscopy imaging, it is well known to the skilled person in the field of electron microscopy that samples, such as hydrated samples, are easily damaged by the irradiation with the beam of electrons used by the electron microscope. The damage can be minimized by observing the sample at cryogenic temperatures. The sample is frozen in such a manner that the water forms amorphous ice to avoid e.g. puncture of cell membranes, etc. by ice crystals. It is thus essential that the sample is kept at a temperature below the glass transition temperature of water at all times, both during milling and during observation with the SPM. It is noted that the glass transition temperature is approximately 136 K.

It is noted that both the milling and the SPM imaging should preferably be done in vacuum to avoid the formation of hoarfrost on the sample, although alternatives, such as the use of a protective atmosphere are envisaged. To avoid problems during the transport between two instruments, the SPM is preferably integrated in the vacuum chamber of the ion milling apparatus

In yet another embodiment of the method according to the invention the scanning probe microscope is an AFM equipped to operating in phase contrast mode.

In this mode of using an AFM the probe is made to vibrate close to the surface of the sample at the resonance frequency Fᵣ of the probe. Due to the small distance between tip and sample damping of the resonance occurs, the damping depending on the distance. By applying an excitation signal and comparing the excitation signal with the actual deflection of the probe, a phase shift can be determined. This phase shift is then used to generate a phase contrast image. This type of imaging is described in e.g. "Application of phase imaging and force modulation mode for description of dispersion of carbon nanotubes in polyol matrix", M. J. Wozniak et al., Materials Science-Poland, Vol. 26, No. 1, 2008, pages 245-253, more specifically section 1.1: "phase imaging", hereby included by reference.

The invention is now elucidated on the hand of figures, in which identical reference numerals refer to corresponding features. In this:

Figure 1 schematically shows an AFM scanning a surface,

Figure 2 schematically shows FIB milling of a surface,

Figure 3 schematically shows the crater formed by repeated ion beam milling by subsequently smaller areas,

Figure 4 schematically shows a combined SPM, FIB and SEM apparatus for performing the method according to the invention.

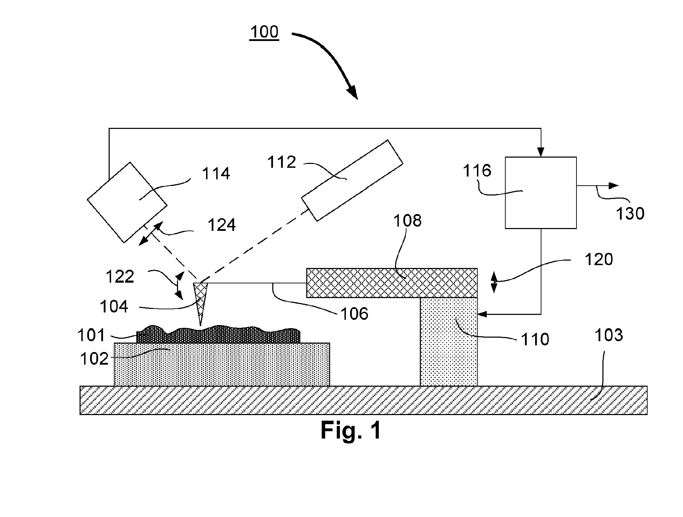

Figure 1 schematically shows an AFM scanning a surface.

The AFM comprises a sharp needle104 that is positioned just above the surface of a sample 101. The needle is mounted on a spring 106, the spring mounted on an exciter 108, in which a piezocrystal 110 makes the exciter vibrate with respect to base 103. The exciter 108 can thus make the needle vibrate at, for example, the natural resonance frequency of the spring 106 with the needle 104 mounted thereupon. The deflection 112 of the spring is determined by irradiation the spring with a laser beam emanating from laser 112 and determining the position 124 where the beam illuminates a position sensitive detector 114.

Sample 100 is mounted on a piezostage 102 that can move the sample with respect to the base 103 in a plane perpendicular to the direction in which the needle 104 moves.

The AFM further comprises a controller 116, controlling the frequency with which the spring 108 is excited, and also controlling the piezostage, thereby scanning the needle with respect to the sample. The controller is equipped to deliver a signal 130 that can be used to generate an image.

The mode in which the needle is vibrating at a very small distance from the surface of the sample ―typically 1 nm or less- is known as tapping mode. It relies on the fact that damping occurs when the needle is at a very small distance from the surface, leading to slight changes in resonance frequency and Q-factor of the spring/needle system.
When imaging the phase shift of the excitation frequency and the deflection of the needle at the unloaded resonance frequency, then the AFM operates in the phase contrast mode.

It this way an image can be made with a resolution of 0.1 nm in the plane of in which the piezostage moves as well as perpendicular on that plane (thus: the direction in which the needle vibrates).

It is noted that the height adjustment necessary for compensating height differences of the sample may be done with the exciter, but as an alternative the piezostage may be equipped with a further degree of freedom.

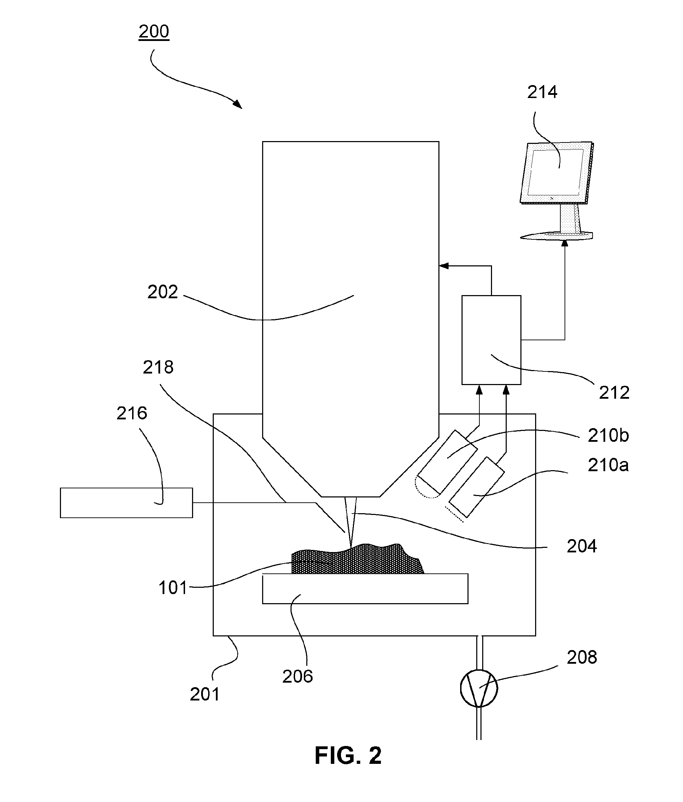

Figure 2 schematically shows FIB milling of a surface.

Figure 2 shows an apparatus 200 comprising a vacuum chamber 201 on which an ion beam column 202 for producing a beam of ions 204 is mounted. The vacuum chamber is evacuated by vacuum pump 208, such as a turbo-molecular pump. The beam of ions is focused on and rastered (or otherwise scanned) over the sample 101, thus milling the sample. A Gas Injection System (GIS) 216 with a capillary 218 is equipped to direct an etchant to the sample. So that the milling effect of the ion beam is enhanced. The sample is placed on a positioning table 206 so that a place of interest can be positioned under the ion beam column. Detectors 210a, 210b detect radiation emanating from the sample as a result of the impinging ion beam. The detectors may detect secondary ions, electrons, and the like. The apparatus further comprises a controller 212 controlling the ion beam column (e.g. acceleration voltage of the ions, focus of lenses in the column, deflection of deflectors in the column, etc., and also accepting the signals of the detectors. Outputted is a video signal to a monitor 214.

Ion beam columns are known as such. For milling purposes a typical column produces a finely focused beam of gallium ions with an energy of between 500 eV and 50 keV, and a current of between 1 pA to 100 nA. The beam is focused in a spot with a diameter of typically between 5 nm and 15 nm, depending on beam current and acceleration voltage. The beam is scanned over an area of, for example, 100 x 100 µm, and material of the sample is sputtered away by the impinging ions. To enhance the milling an etchant, such as H₂O or HF can be directed to the place where the ion beam hits the sample.

It is noted that, instead of milling, also ion beam deposition can be performed by choosing the beam parameters and gas type differently.

It is further noted that the apparatus may be equipped with another column for delivering a focused electron beam. Such a beam can typically be focused in a smaller spot, thus offering a higher resolution, and can be used to produce X-rays from the sample to be detected by an X-ray detector (not shown).

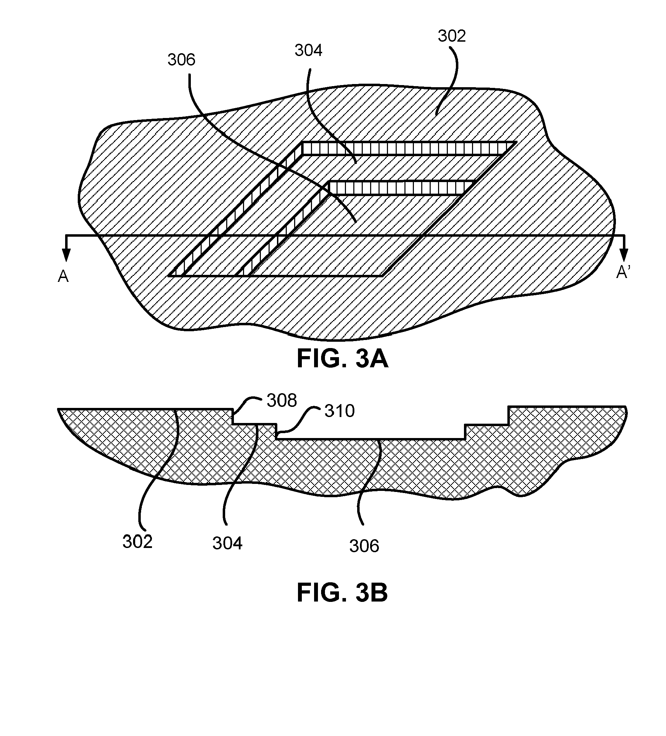

Figure 3a schematically shows the surface 302 of a sample.

In the surface of the sample a first box with a first surface 304 is milled. Afterwards a smaller box with a second surface 306 is milled within the first box.

Figure 3b shows a sectional view through the sample along line AA' as shown in figure 3a.

Surface 302 of the sample is milled to a first box with a first surface 304, in with a second box with a second surface 306 is milled. The step between the surface 302 and surface 304, step 308, can be measured with an AFM, as can the step 310 between surface 304 and the surface 306.

By scanning the AFM over the surface 302 before milling the first box, then by scanning the AFM over the surface formed by milling the first box, then by scanning the surface by milling the second box, etc., a series of surfaces is recorded. Their distance from the original surface is easily reconstructed by determining the steps. As a result a 3D map of the removed volume can be reconstructed as observed by the AFM.

It is noted that similarly a stack of surface images made with an electron beam column can be made, resulting in a supplementary 3D map. Also images made with the ion beam column can be used.

It is further noted that the height of the removed area, steps 308 and 310, can be determined or estimated by the speed with which the milling takes place, or by determining the step height with the AFM. Also other height determining apparatus, such as a profilometer, can be used.

As known to the person skilled in the art of ion beam milling, this is done in a vacuum of typically between 10⁻⁴ Pa to 100 Pa (when admitting an etchant in the vacuum chamber). It is especially attractive to perform the scanning with the AFM in the same vacuum so that the sample can stay in the same evacuated area without further cycling of the pressure. This becomes even more attractive when the sample is kept at cryogenic temperatures to avoid condensation and freezing of water on the sample, thus making it impossible to observe the surface.

It is noted that in figure 3 it is described that the surfaces are nested within each other. This is in general not necessary, and reference to one point, e.g. on the original surface 302 is suited to determine the step caused by the removal of material

It is further noted that the ion beam may be a beam of ions focused on the surface that is scanned over the surface, or a beam of ions that is out of focus, or a non-focused beam of ions. The type of ions can be chosen to fit the application, e.g. gallium for a focused ion beam, or a noble gas from a plasma for a non-focused beam.

It is mentioned that figure 2 shows a milling instrument where the ion beam impinges perpendicular to the sample. A SPM as shown in figure 1 has a tip that vibrates perpendicular to the sample surface as well.
It is expressly mentioned that it is not necessary to do the 'tapping' (vibration of the SPM) and the milling with the same angle, i.e. both perpendicular to the surface of the sample. In such an instrument the SPM may tap perpendicular to the sample surface and ion beam milling at a slanted or even glancing angle. As known to the person skilled in the art of ion beam milling such milling at a glancing angle results in a milled surface with very low roughness, e.g. 2 nm_{RMS}.

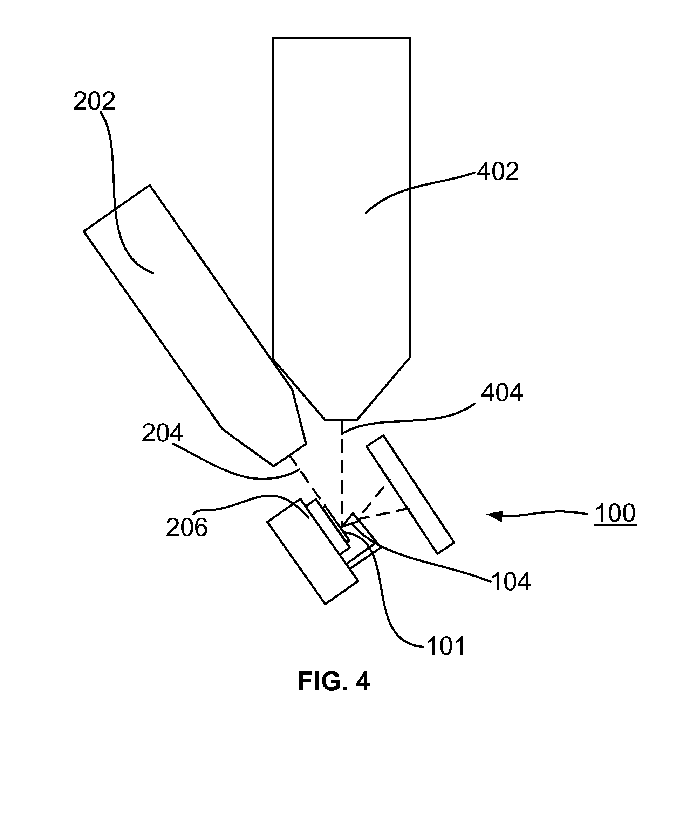

Figure 4 schematically shows a combined SPM, FIB and SEM apparatus for performing the method according to the invention.

Figure 4 shows an apparatus where the ion beam column 202 for milling the sample is oriented such that the ion beam 204 glances over the sample 101. For simplicity the detectors, controllers, vacuum chamber, vacuum pumps, and the like as shown in figure 2, which are obvious to the person skilled in the art, are not shown here.
A SPM 100 with probe 104 is mounted on positioning table 206. A Scanning Electron Microscope column 402 scans an electron beam 404 over the sample, thus providing supplemental images that can be used to provide supplemental 3D maps. The detectors (not shown in figure 4, see figure 2) may detect secondary electrons, back-scattered electrons, X-rays, and the like. A supplemental image with nanometer resolution may be formed
It is noted that by changing the position of the sample slightly between the imaging with the electron beam and imaging with the SPM may reduce interference of the field of view of the SEM column and the SPM.

We claim as follows:

## Claims

1. Method of inspecting a sample (101), the method comprising:
repeatedly
• Preparing a fresh surface (304, 306) on the block face of a sample by removing the surface layer,
• Inspecting the block face with a scanning probe microscope (100), resulting in information of the current surface layer,
Followed by
• Combining the information of a multitude of inspections into a 3D reconstruction of the sample,
**Characterized in that**
The removal is performed in an evacuated environment by ion beam milling.

2. The method of claim 1 in which the ion beam milling is focused ion beam milling.

3. The method of any of the preceding claims in which the milling is performed in a vacuum chamber (201) and an etchant is introduced in the vacuum chamber during the ion beam milling.

4. The method of any of the preceding claims in which the scanning probe microscope (100) is an Atomic Force Microscope (AFM), a Ballistic Electron Emission Microscope (BEEM), a Chemical Force Microscope (CFM), a Conductive Atomic Force Microscope (C-AFM), an Electrostatic Force Microscope (EFM), a Force Modulation Microscope (FMM), a Kelvin Probe Force Microscope (KPFM), a Magnetic Force Microscope (MFM), a Magnetic Resonance Force Microscope (MRFM), a Scanning Near-Field Optical Microscope (SNOM), a Piezoresponse Force Microscope (PFM), a Photon Scanning Tunneling Microscope (PSTM), a Photothermal Microspectroscopy Microscope (PTMSM), a Scanning ElectroChemical Microscope (SECM), a Scanning Capacitance Microscope (SCM), a Scanning Gate Microscope (SGM), a Scanning Ion-Conductance Microscope (SICM), a Spin Polarized Scanning Tunneling Microscope (SP-STM), a Scanning Spreading Resistance Microscope (SSRM) a Scanning Thermal Microscope (SThM), a Scanning Tunneling Microscope (STM), a Scanning Voltage Microscope (SVM), or a Scanning Hall Probe Microscope (SHPM).

5. The method of any of the preceding claims in which inspecting the sample (101) further comprises inspecting the sample with FIB imaging, resulting in one or more supplemental 3D maps of the sample

6. The method of any of the preceding claims in which inspecting the sample (101) further includes inspecting the sample with a focused electron beam, resulting in one or more supplemental 3D maps of the sample.

7. The method of claim 6 in which the one or more supplemental 3D maps comprise information of position dependent secondary electron emission, bse, x-ray, cathodo-luminescence.

8. The method of claim 5 in which the one or more supplemental 3D maps comprise information of position dependent secondary electron emission or secondary ion emission.

9. The method of any of the preceding claims in which the thickness of the removed layer of material is determined with the scanning probe microscope (100).

10. The method of any of the preceding claims in which the scanning probe microscope (100) is operates in vacuum.

11. The method of any of the preceding claims in which the sample (101) is a biological sample or a polymer.

12. The method of any of the preceding claims in which the sample (101) is a sample at cryogenic temperature, and the AFM is equipped to operate in vacuum at a cryogenic temperature.

13. The method of any of the preceding claims in which the scanning probe microscope (100) is an AFM equipped to operating in phase contrast mode.

14. The method of any of the preceding claims in which the scanning probe microscope (100) operates in the vacuum environment where the ion beam milling takes place.
